Europäisches Patentamt

European Patent Office

Office européen des brevets

(19)

(11) Numéro de publication : **0 434 480 A1**

# (12) DEMANDE DE BREVET EUROPEEN

(21) Numéro de dépôt : 90403243.0

(22) Date de dépôt : 16.11.90

(51) Int. Cl.⁵ : **C04B 35/00, H01L 39/24, C25D 11/00, C04B 41/00**

Le titre de l'invention a été modifié (Directives relatives à l'examen pratiqué à l'OEB, A-III, 7.3)

(30) Priorité : 01.12.89 FR 8915856
10.08.90 FR 9010241

(43) Date de publication de la demande :
26.06.91 Bulletin 91/26

(84) Etats contractants désignés :
AT BE CH DE DK ES FR GB GR IT LI LU NL SE

(71) Demandeur : RHONE-POULENC CHIMIE
25, quai Paul Doumer
F-92408 Courbevoie Cédex (FR)

(72) Inventeur : Demourgues, Alain
2ter, rue de Bethmann, Res.Mahela-Bât B.
App. 117
F-33000 Bordeaux (FR)
Inventeur : Fournes, Léopold
Résidence Cassini
F-33610 Sestas (FR)
Inventeur : Grenier, Jean-Claude
Vénalin-Impasse des Pins
F-33140 Cadaujac (FR)
Inventeur : Pouchard, Michel
Bellegrave Le Poujeau
F-33290 Le Pian-Medoc (FR)
Inventeur : Wattiaux, Alain
3, Rue de la Marne
F-33127 Martignas-sur-Jalles (FR)

(74) Mandataire : Dubruc, Philippe et al
RHONE-POULENC CHIMIE Service Brevets
Chimie 25, quai Paul-Doumer
F-92408 Courbevoie Cédex (FR)

(54) Procédé de traitement électrochimique d'un matériau sous forme d'oxyde.

(57) L'invention concerne le traitement d'un matériau sous forme oxyde en vue de faire varier sa stoechiométrie anionique ainsi que les produits obtenus par celui-ci.

Le traitement peut être appliqué aux supraconducteurs, aux matériaux à comportement semi-conducteur ou métallique, ou aux précurseurs de tels matériaux.

Ledit traitement consiste à utiliser le matériau sous forme d'électrode lors d'une électrolyse dans un milieu liquide, notamment neutre ou basique.

EP 0 434 480 A1

# PROCEDE DE TRAITEMENT ELECTROCHIMIQUE D'UN MATERIAU SOUS FORME OXYDE, APPLICATION AUX SUPRACONDUCTEURS, AUX MATERIAUX A COMPORTEMENT SEMI-CONDUCTEUR OU METALLIQUE ET PRODUITS OBTENUS

La présente invention concerne un procédé de traitement électrochimique d'un matériau sous forme oxyde en vue de faire varier sa stoechiométrie. Il s'applique particulièrement aux matériaux supraconducteurs ou à comportement semi-conducteur ou métallique, ou aux précurseurs de tels matériaux. L'invention concerne aussi les matériaux obtenus notamment par ce procédé.

On entend ici et pour le reste de la description par précurseur un matériau ne présentant pas de caractère supraconducteur, semi-conducteur ou métallique mais qui après le traitement selon l'invention présente de telles propriétés.

On sait que les recherches dans le domaine des supraconducteurs ont connu un développement considérable depuis peu de temps.

La grande majorité des phases supraconductrices à haute température critique qui ont résulté de ces recherches sont des oxydes ternaires, quaternaires ou plus, à base de cuivre notamment.

Leur préparation impose des traitements oxydants qui sont généralement des recuits à haute température sous pression d'oxygène faible, moyenne ou élevée. De tels traitements sont coûteux en énergie et d'une mise en oeuvre délicate car la pression en oxygène doit être soigneusement contrôlée pour espérer une maîtrise parfaite de l'oxydation du matériau qui est une condition essentielle de sa supraconductivité.

On a cherché à résoudre ce problème d'oxydation en faisant appel à une méthode électrochimique dont le principe très général est décrit dans le document de brevet WO 88/09061.

Toutefois, ce document concerne l'utilisation d'une pile de concentration à oxygène mettant en oeuvre un électrolyte solide, ou l'intercalation de lithium en milieu sel fondu pour contrôler la valence du cuivre. Or dans de tels cas, on est généralement obligé de travailler à des températures élevées d'au moins 600°C.

Outre le problème du coût en énergie mentionné plus haut, on doit prendre en compte que certaines phases ne sont plus stables à ces températures élevées et donc que leur traitement par un tel procédé est impossible.

Le problème est du même ordre lorsqu'il s'agit de phases à comportement semi-conducteur ou métallique, ou leurs précurseurs.

En effet, l'oxydation de telles phases est habituellement effectuée dans des conditions de température et de pression élevées, entraînant les mêmes inconvénients de coût et de stabilité des phases que ceux rencontrés pour les phases supraconductrices ou précurseurs de celles-ci.

On voit donc qu'il y a un besoin réel d'un procédé permettant de faire varier la stoechiométrie anionique de matériaux notamment supraconducteurs et offrant éventuellement une bonne maîtrise de l'oxydation de ces matériaux dans des conditions douces.

Un premier objet de l'invention est un tel procédé.

Un second objet de l'invention est constitué par des matériaux supraconducteurs ou à comportement semi-conducteur ou métallique pouvant être obtenus notamment par ce procédé.

Dans ce but, le procédé selon l'invention de traitement électrochimique d'un matériau sous forme oxyde pour faire varier sa stoechiométrie anionique est caractérisé en ce qu'on utilise ledit matériau comme électrode dans une électrolyse dans un milieu liquide notamment neutre ou basique.

Selon un mode de réalisation particulier de l'invention, le matériau précité est un supraconducteur ou un précurseur d'un tel matériau.

Enfin, l'invention concerne aussi un matériau supraconducteur ou à comportement semi-conducteur ou métallique caractérisé en ce qu'il est obtenu à partir d'un premier matériau sous forme oxyde traité par un procédé dans lequel ledit premier matériau est utilisé comme électrode dans une électrolyse dans un milieu liquide notamment neutre ou basique.

Le procédé de l'invention offre des avantages certains. Il permet tout d'abord de travailler à la température ambiante ou à des températures voisines et de ce fait, comme évoqué plus haut, il peut s'appliquer à une large gamme de matériaux en particulier à tous ceux qui ne sont pas stables à des températures élevées. On notera enfin à ce sujet qu'il n'était d'ailleurs pas évident qu'un tel traitement électrochimique pouvait être efficace à la température ambiante, compte tenu de l'enseignement du document WO 88/09061.

En outre, le traitement selon l'invention peut offrir une bonne maîtrise de l'oxydation. Il permet ainsi pour un matériau donné de lui conférer des propriétés électriques particulières et notamment supraconductrices par introduction ou intercalation contrôlée d'espèces oxygénées dans le matériau.

Le procédé selon l'invention permet aussi de conférer à un matériau isolant des propriétés de semi-conducteur ou un comportement métallique, ou encore conférer à un matériau semi-conducteur un comportement métallique.

On peut de même améliorer les propriétés supraconductrices d'un matériau, voire transformer un matériau non supraconducteur à l'origine en matériau supraconducteur.

On notera enfin que le procédé de l'invention conduit à une oxydation massique du matériau traité, ce qui permet l'obtention de propriétés électriques ou de supraconductivité massiques le cas échéant.

D'autres caractéristiques et détails de l'invention apparaîtront mieux à la lecture de la description qui va suivre et des dessins annexés pour lesquels :

- La figure 1 est une courbe donnant la résistivité électrique $\rho$ en Ohm. cm en fonction de la température en K pour un matériau $La_2CuO_{4 \pm \delta}$ avant traitement selon l'invention ;
- La figure 2 est une courbe donnant la résistivité électrique $\rho$ en Ohm. cm en fonction de la température en K pour le matériau précédent mais après traitement selon l'invention ;
- La figure 3 est une courbe donnant la susceptibilité magnétique par gramme du matériau de la figure 2 exprimée en uem CGS en fonction de la température en K pour un champ appliqué de 300 Gauss.

La présente invention s'applique à tout type d'oxydes notamment ternaires ou quaternaires.

Elle s'applique aussi tout particulièrement aux phases de type perovskite ou dérivées de la perovskite et notamment aux phases supraconductrices.

Parmi celles du type perovskite, on peut citer les matériaux de formule :

$$A_{1-x} A'_{x'} BO_{3 \pm y} \quad (1)$$

dans laquelle :

A et A' sont identiques ou non et représentent un élément choisi parmi les éléments des groupes IA, IIA, IIIA, IIIB, IVB, VB et de la série 4f de la classification périodique ;

B est un élément de transition notamment choisi parmi les éléments des groupes IIIA, IVA, VA, VIA, VIIA, VIII, IB, IIB ;

x, x' et y sont des nombres identiques ou différents variant entre 0 et 1 inclus.

Pour la formule (1) donnée ci-dessus et pour l'ensemble de la description, la classification périodique à laquelle il est fait référence est celle donnée dans l'ouvrage Advanced Inorganic Chemistry 4ème édition F. A. COTTON et G. WILKINSON (John WILLEY and SONS).

Plus particulièrement, on peut mentionner les matériaux pour lesquels A et A' sont le lanthane ou une terre rare, le bismuth, le thallium, l'yttrium, le baryum, le strontium, le calcium ou le plomb.

B peut être plus particulièrement le cuivre.

On peut citer à titre d'exemple les phases $Y Ba_2 Cu_3 O_{7-\delta}$.

Selon une variante de ce premier mode de réalisation de l'invention, on peut mettre en oeuvre les phases correspondant à la formule (1) dans laquelle A et A', identiques ou non, représentent un élément choisi parmi les éléments des groupes Ia, IIa ou de la série 4f, dans laquelle B est un élément de la première, deuxième ou troisième série de transition et dans laquelle x = x' et x et y varient entre 0 et 1 inclus.

Plus particulièrement, on peut mentionner les matériaux pour lesquels A et A' sont le sodium, le potassium, le baryum, le calcium, le strontium, l'yttrium, le lanthane ou une terre-rare.

Par ailleurs, B peut être le fer, le cobalt, le nickel, le cuivre, l'or ou l'argent.

De préférence, ladite phase comprend un élément de la colonne IIA. D'autre part, selon un autre mode préféré, ladite phase comprend un élément de la première série de transition.

Par ailleurs, on peut mettre en oeuvre l'invention avec des phases correspondant à la formule (1) et dans laquelle y varie entre 0,45 et 0,5.

Enfin, la phase à traiter peut correspondre à la formule (1) dans laquelle x = 0.

A titre d'exemple, on peut citer $CaFeO_3$, $SrFeO_3$.

On peut aussi mettre en oeuvre les phases dérivées de la perovskite notamment celles de formule :

$$A_{n+1} B_n O_{3n+1 \pm \delta} \quad (2)$$

dans laquelle A et B ont la même définition que celle de la formule (1), n est un nombre au moins égal à 1 et $\delta$ un nombre compris entre 0 et 1 inclus. Il s'agit là notamment des perovskites à couches.

Selon une variante de ce second mode de réalisation, A et A' sont choisis parmi le lanthane ou une terre-rare ou l'yttrium et B est choisi parmi les éléments de la première série de transition.

On peut citer à titre d'exemple la phase $La_2CuO_4$.

La présente invention s'applique aussi aux matériaux de formules :

$$(AO)_m A'_2 A''_{n-1} B_n O_{2n+2 \pm \delta} \quad (3)$$

$$(AO)_m A'_2 A''_{n-1} B_{n+1} O_{2n+2 \pm \delta} \quad (4)$$

dans lesquelles :

A est un élément choisi parmi ceux des groupes IIIB, IVB et VB de la classification périodique ;

A' est un élément choisi parmi ceux des groupes IA, IIA, IIIA ou de la série 4f ;

A'' est un élément choisi parmi ceux des groupes IA, IIA, IIIA, IIIB, IVB, VB et de la série 4f ;

B est un élément de transition notamment choisi parmi les éléments des groupes IIIA, IVA, VA, VIA, VIIA, VIII,

EP 0 434 480 A1

IB et IIB ;

m est un nombre compris entre 1 et 2 inclus

n est un nombre variant entre 1 et 5 inclus, $\delta$ est un nombre variant entre 0 et 1 inclus.

Il s'agit là notamment des perovskites lamellaires.

On peut citer plus particulièrement les produits pour lesquels A est le plomb, le bismuth ou le thallium, A' le strontium ou le baryum et A" est le calcium, le strontium ou l'yttrium.

A titre d'exemple de produits selon la formule (4), on peut mentionner la phase $(PbO)_2Sr_2YCu_3O_6$.

Enfin, on peut aussi utiliser dans le cadre de la présente invention les matériaux de formule :

$$(AO)_m \, A'_{n-1} \, B_n \, O_{3n+1} \pm \delta \quad (5)$$

dans laquelle :

A est le bismuth, A' est le strontium, le baryum, le plomb ou le bismuth ;

B est un élément de transition notamment choisi parmi les éléments des groupes IIIA, IVA, VA, VIA, VIIA, VIII, IB et IIB ;

m et n sont des nombres identiques ou différents variant de 1 à 5 inclus ;

$\delta$ est un nombre variant entre 0 et 1 inclus.

Ces phases correspondent aux phases d'Aurivillius.

Selon l'invention, le matériau que l'on souhaite traiter est utilisé comme électrode de travail. En d'autres termes, ce matériau va constituer une partie de l'électrode employée dans l'électrolyse.

Le matériau à traiter peut être alors utilisé sous différentes formes. On peut d'abord l'employer sous forme massique ou sous forme d'une poudre mise en forme par compression. Cette poudre comprimée peut éventuellement avoir été frittée.

Le matériau peut aussi être mis en oeuvre sous forme d'une couche mince ou épaisse sur un support qui sera choisi inerte dans le milieu utilisé, notamment en milieu neutre ou basique. Le matériau peut éventuellement aussi être utilisé sous forme d'un monocristal.

Le contact électrique entre le matériau et le porte-électrode sera assuré d'une manière connue en soi.

L'électrolyse peut être réalisée dans toute installation convenable. On utilisera de préférence une cellule d'électrolyse à deux compartiments, séparés par exemple par un fritté.

On peut travailler avec deux électrodes, l'électrode de travail comprenant le matériau à traiter et une contre-électrode. Cependant, de manière à mieux contrôler le potentiel, on préfère un montage à trois électrodes, la troisième électrode étant une électrode de référence.

On utilisera pour la contre-électrode et l'électrode de référence tout matériau convenable et adapté au milieu de travail.

L'électrode de référence pourra être une électrode au mercure (HgO/Hg), à l'hydrogène, au calomel par exemple. La contre-électrode présentera une surface importante et pourra être en graphite, en platine, en or notamment.

Il peut être avantageux d'utiliser une électrode de travail à disque tournant.

Selon une caractéristique essentielle de l'invention, l'électrolyse se fait en milieu liquide.

On entend ici par milieu liquide un milieu qui est liquide aux basses températures auxquelles on met en oeuvre la présente invention.

Plus précisément, cela signifie des températures généralement inférieures à 100°C, plus particulièrement la température ambiante (20-25°C) ou le voisinage de celle-ci. On exclut donc ici le milieu du type sel fondu.

Généralement, le milieu électrolytique du procédé de l'invention est un milieu neutre ou basique.

Selon un mode de réalisation particulier de l'invention, le milieu est un milieu aqueux et notamment alcalin.

Habituellement pour former le milieu on utilise comme base un hydroxyde alcalin ou alcalino-terreux tel que par exemple NaOH, KOH, LiOH, $NH_4OH$, éventuellement $Ba(OH)_2$, $Ca(OH)_2$. On peut utiliser un mélange de ces bases.

Le pH du milieu doit être choisi tel que le matériau à traiter puisse résister au milieu. Il varie habituellement entre 7 et 15 inclus, de préférence entre 13 et 15.

L'électrolyse se fait en appliquant une polarisation anodique ou cathodique à l'électrode de travail.

Dans le cas d'une polarisation anodique, la valeur de ce potentiel (déterminé par rapport à une électrode de référence au mercure (HgO/Hg), est fonction du matériau traité et est généralement d'au moins 200 mV. Cette valeur est habituellement comprise entre 200 et 1500 mV. Elle peut notamment être située entre 500 et 1100 mV.

Selon un autre mode de réalisation de l'invention et dans le cas du traitement des phases correspondant à la variante du premier mode de réalisation, la valeur dudit potentiel est d'au moins 200 mV. Il est généralement compris entre 200 et 1500 mV et plus particulièrement entre 200 et 500 mV.

Dans tous les cas, la valeur supérieure du potentiel reste inférieure à celle à laquelle se produit le dégagement de l'oxygène sur le matériau à traiter utilisé comme électrode.

4

Selon une caractéristique intéressante de l'invention, le procédé est mis en oeuvre à basse température. Comme on vient de l'indiquer plus haut, on entend par là une température inférieure à 100°C. Habituellement, on travaille à la température ambiante (20-25°C) ou au voisinage de celle-ci par exemple entre 10 et 40°C.

Enfin, on peut travailler sous air, sous atmosphère d'azote, d'argon ou sous oxygène, à la pression atmosphérique ou à une pression légèrement supérieure à celle-ci.

Un autre aspect de l'invention est constitué par les produits nouveaux que permet d'obtenir le procédé qui vient d'être décrit ci-dessus.

En effet, les produits ainsi obtenus se distinguent de ceux de l'art antérieur par le fait qu'ils constituent dans certains cas de nouvelles phases supraconductrices ou, dans d'autres cas, qu'ils présentent des propriétés supraconductrices améliorées par rapport à des produits de compositions analogues déjà connus comme supraconducteurs.

Les matériaux de l'invention peuvent être définis par leur procédé de préparation, auquel cas tout ce qui a été mentionné plus haut pour le procédé, s'applique ici pour la définition de ces produits.

Des exemples concrets mais non limitatifs vont maintenant être donnés.

## EXEMPLE 1

Le matériau à traiter est $La_2CuO_4 \pm \delta$.

Il est formé par réaction à l'état solide à l'air à 1050°C en 18 heures de $La_2O_3$ et CuO, pris en proportion stoechiométrique. Il est ensuite trempé à l'air à cette même température.

La poudre obtenue, compressée sous 2 T en forme de pastilles ou disques de 8 mm de diamètre et 2 mm d'épaisseur, est frittée à 1050°C à l'air pendant 16 heures puis trempée à l'air.

La céramique ainsi obtenue présente les caractéristiques suivantes :

- comportement semi-conducteur

$\rho$ 300K = 0,4 $\Omega$ cm $\rho$ 4,2K = 40 $\Omega$ cm

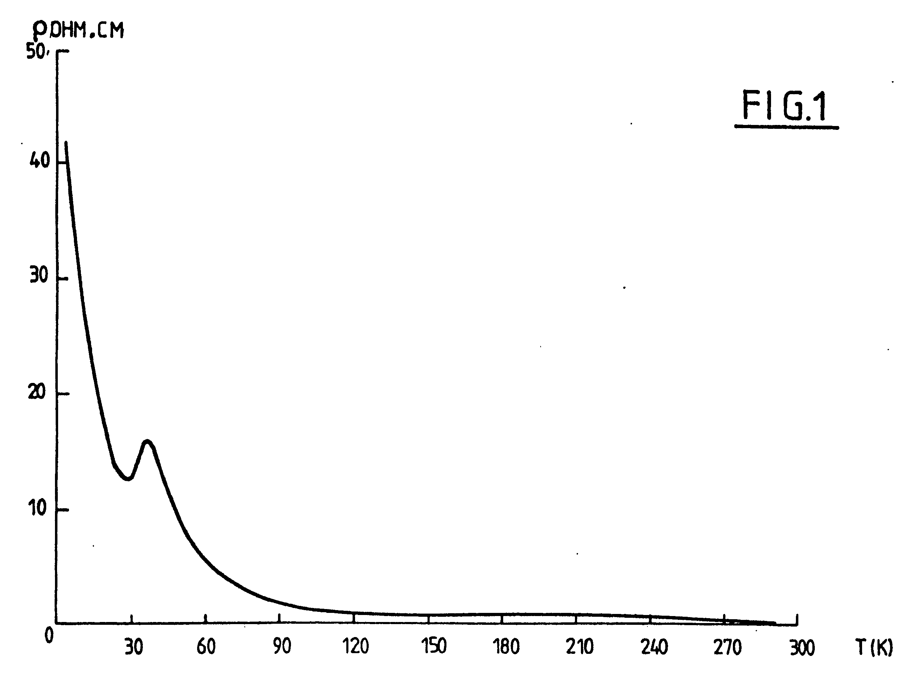

Ce comportement apparaît sur la figure 1.

- structure orthorhombique

a = 5,352 Å

b = 5,405 Å

c = 13,165 Å

Les conditions d'électrolyse sont ensuite les suivantes :

- cellule à deux compartiments

- montage à trois électrodes :

une électrode de référence HgO/Hg, KOH 1N

une contre-électrode Au

L'électrode de travail est une électrode à disque tournant. Elle est équipée d'un embout cylindrique métallique sur lequel est fixée la pastille de matériau.

Le contact ohmique est assuré par une laque d'argent. Un enrobage est effectué à l'aide d'une résine thermodurcissable de manière à assurer le contact électrolyte disque du matériau par une seule face de celui-ci.

- le montage est potentiostatique. La polarisation E est égale à 900 mV (HgO/Hg)

- l'électrolyte est une solution de KOH 1N

- la température est de 25°C

- l'électrolyse se fait à l'air pendant 66 heures.

Après l'électrolyse, on obtient un matériau présentant une structure orthorhombique de paramètres :

a = 5,351 Å

b = 5,420 Å

c = 13,227 Å

voisine de celle du matériau de départ (augmentation du volume de la maille d'environ 1%).

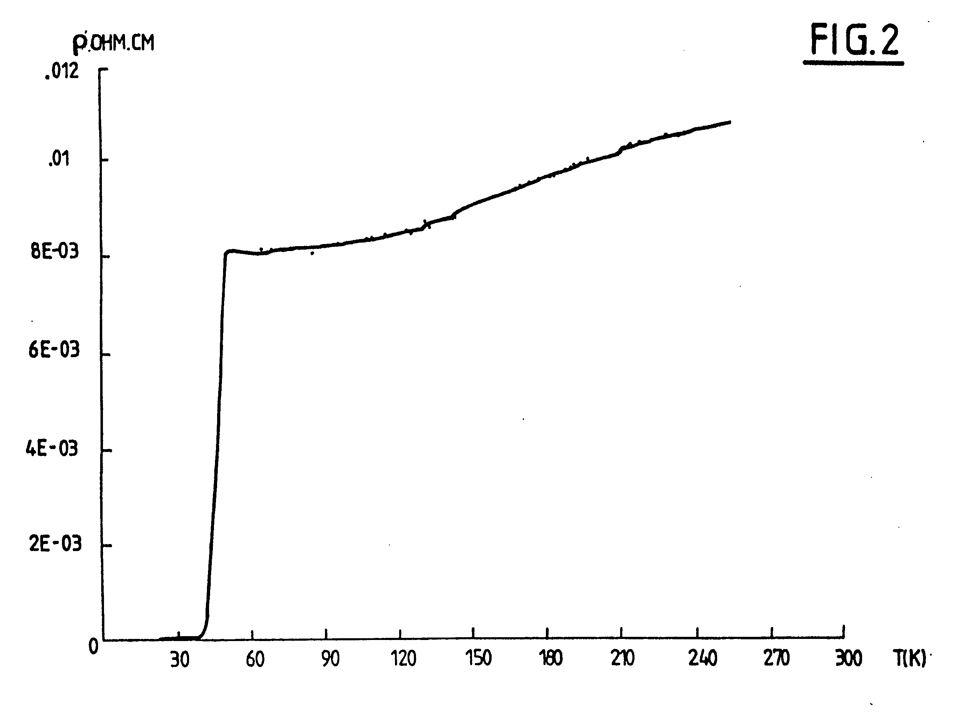

Comme cela apparaît sur la figure 2, le matériau a un comportement électrique métallique à 300K $\rho$ 300K $\simeq$ 0,01 $\Omega$ cm et supraconducteur à basse température.

Il présente une Tc (onset) de 49K et une Tc (p = 0) de 31K.

Les études des propriétés magnétiques montrent une susceptibilité diamagnétique en-dessous de Tc = 39K.

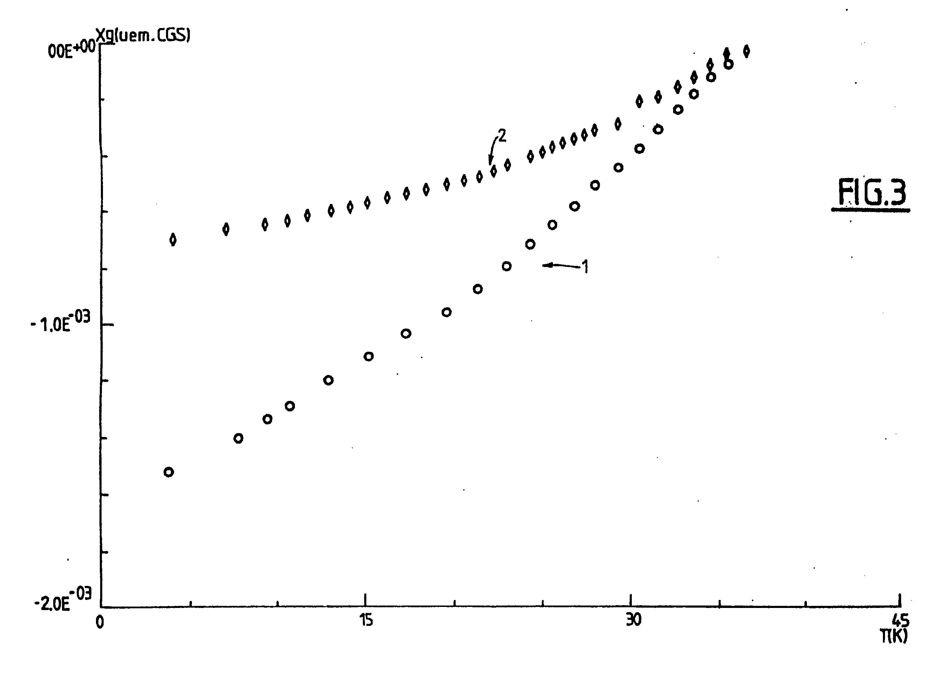

La figure 3 représente les courbes typiques obtenues pour l'effet d'écran (courbe 1) et l'effet Meissner (courbe 2).

## EXEMPLE 2

Le matériau à traiter est de composition $SrFeO_{2,50}$.

Il est formé par réaction à l'état solide de $SrCO_3$ et $Fe_2O_3$ à 950°C pendant 12 heures, puis à 1200°C pendant 6 heures, sous air, avant d'être trempé.

Le produit résultant est ensuite recuit à 1300°C pendant 48 heures sous air.

Enfin, la phase $SrFeO_{2,50}$ est obtenue par réduction du produit recuit à 1000°C sous courant d'argon pendant 18 heures suivie d'une trempe sous argon.

La valeur de la résistance à 298 K est de $2.10^{-6}(\Omega.cm)^{-1}$, caractéristique d'un matériau isolant.

On réalise ensuite une pastille de 8 mm de diamètre sur 2 mm d'épaisseur (correspondant à une masse de produit de 400 mg) puis on effectue un recuit de celle-ci sous courant d'argon à 1000°C pendant 4 heures.

Le dosage chimique de la poudre indique un produit de composition $SrFeO_{2,53 \pm 0,02}$.

L'analyse par diffraction aux rayons X montre que la maille est orthorhombique avec les paramètres suivants :

$a = 5,519 \pm 0,005$ Å

$b = 15,54 \pm 0,01$ Å

$c = 5,662 \pm 0,005$ Å

L'analyse par spectroscopie Mössbauer indique que le fer est à 94% sous forme de fer (III).

Le spectre Mössbauer est constitué de deux sextuplets magnétiques.

Les paramètres Mössbauer sont les suivants :

| Site | % Fe (III)* | $\delta(mm.s^{-1})$ | H (T) |
|---|---|---|---|
| octaédrique ($O_h$) | 50 | 0,376 | 49,7 |
| tétraédrique ($T_d$) | 50 | 0,189 | 41,1 |

avec $\delta$ : déplacement isomérique

H : champ magnétique hyperfin.

\* : le pourcentage de fer est ramené à la quantité totale de fer trivalent.

Les conditions d'électrolyse sont ensuite les suivantes :

- cellule à deux compartiments
- montage à trois électrodes :
une électrode de référence HgO/Hg, KOH 1N
une contre-électrode Au

L'électrode de travail est une électrode à disque tournant. Elle est équipée d'un embout cylindrique métallique sur lequel est fixée la pastille de matériau à traiter.

Le contact ohmique est assuré par une laque d'argent. Un enrobage est effectué à l'aide d'une résine thermodurcissable de manière à assurer le contact électrolyte disque du matériau par une seule face de celui-ci et de garantir l'étanchéité de l'ensemble.

- le montage est potentiostatique. La polarisation E est égale à 400 mV/(HgO/Hg)
- l'électrolyte est une solution de KOH 1N
- la température est de 20°C et la pression partielle d'oxygène est de 0,2.
- l'électrolyse se fait à l'air pendant 60 heures.

Après l'électrolyse, on obtient un matériau présentant une structure cubique de paramètre $a = 3,845 \pm 0,007$ Å.

La phase est pure et bien cristallisée.

L'analyse chimique indique une phase de composition $SrFeO_{3,00 \pm 0,02}$.

La valeur de la résistance à 298 K est de $0,2 (\Omega.cm)^{-1}$, ce qui indique un comportement métallique du matériau.

L'analyse par spectroscopie Mössbauer indique que tout le fer est sous forme Fe (IV).

Le spectre Mössbauer est constitué d'un singulet paramagnétique de déplacement isomérique caractéristique du fer tétravalent ($\delta = 0,082$ mm.s$^{-1}$).

La largeur à mi-hauteur du pic est relativement faible ($\Gamma = 0,494$ mm.s$^{-1}$) et confirme la présence Fe (IV) dans un seul site.

L'éclatement quadrupolaire étant nul, l'environnement est parfaitement symétrique et correspond à un empilement d'octaèdres réguliers.

**Revendications**

1. Procédé de traitement électrochimique d'un matériau sous forme oxyde pour faire varier sa stoechiométrie anionique, caractérisé en ce qu'on utilise ledit matériau comme électrode dans une électrolyse dans un milieu liquide.

2. Procédé selon la revendication 1, caractérisé en ce que le milieu liquide est un milieu neutre ou basique.

3. Procédé selon la revendication 1 ou 2, caractérisé en ce que le milieu liquide est un milieu aqueux.

4. Procédé selon l'une des revendications 1 à 3, caractérisé en ce que le matériau précité est un supraconducteur ou un précurseur d'un tel matériau.

5. Procédé selon l'une des revendications précédentes, caractérisé en ce que le matériau précité est du type perovskite ou dérivé de perovskite.

6. Procédé selon la revendication 5, caractérisé en ce que le matériau précité répond à la formule :
$$A_{1-x} A'_{x'} BO_{3 \pm y} \quad (1)$$
dans laquelle :
A et A' sont identiques ou non et représentent un élément choisi parmi les éléments des groupes IA, IIA, IIIA, IIIB, IVB, VB et de la série 4f de la classification périodique ;
B est un élément de transition notamment choisi parmi les éléments des groupes IIIA, IVA, VA, VIA, VIIA, VIII, IB, IIB ;
x, x' et y sont des nombres identiques ou différents variant entre 0 et 1 inclus.

7. Procédé selon la revendication 6, caractérisé en ce que le matériau correspond à la formule (1) dans laquelle A et A' sont choisis parmi les éléments du groupe IIA et B est choisi parmi les éléments de la première série de transition.

8. Procédé selon la revendication 5, caractérisé en ce que le matériau précité répond à la formule :
$$A_{n+1} B_n O_{3n+1} \pm \delta \quad (2)$$
dans laquelle :
A est un élément choisi parmi les éléments des groupes IA, IIA, IIIA, IIIB, IVB, VB et de la série 4f de la classification périodique ;
B est un élément de transition notamment choisi parmi les éléments des groupes IIIA, IVA, VA, VIA, VIIA, VIII, IB, IIB ;
n est un nombre au moins égal à 1 et $\delta$ est un nombre compris entre 0 et 1 inclus.

9. Procédé selon la revendication 8, caractérisé en ce que le matériau correspond à la formule (2) dans laquelle A est choisi parmi les éléments de la série 4f et B parmi les éléments de la première série de transition.

10. Procédé selon la revendication 5, caractérisé en ce que le matériau précité répond aux formules :
$$(AO)_m A'_2 A''_{n-1} B_n O_{2n+2} \pm \delta \quad (3)$$

$$(AO)_m A'_2 A''_{n-1} B_{n+1} O_{2n+2} \pm \delta \quad (4)$$
dans lesquelles :
A est un élément choisi parmi ceux des groupes IIIB, IVB et VB de la classification périodique ;

A' est un élément choisi parmi ceux des groupes IA, IIA, IIIA ou de la série 4f ;

A" est un élément choisi parmi ceux des groupes IA, IIA, IIIA, IIIB, IVB, VB et de la série 4f ;

B est un élément de transition notamment choisi parmi les éléments des groupes IIIA, IVA, VA, VIA, VIIA, VIII, IB et IIB ;

m est un nombre compris entre 1 et 2 inclus

n est un nombre variant entre 1 et 5 inclus, $\delta$ est un nombre variant entre 0 et 1 inclus.

11. Procédé selon la revendication 5, caractérisé en ce que le matériau répond aux formules (3) ou (4) pour lesquels A = Pb, Bi, Tl A' = Sr ou Ba ; A" = Ca, Sr, Y.

12. Procédé selon la revendication 4, caractérisé en ce que le matériau répond à la formule $(AO)_m A'_{n-1} B_n O_{3n+1} \pm \delta$ (5) dans laquelle :

A est le bismuth, A' est le strontium, le baryum, le plomb ou le bismuth, B est un élément de transition notamment choisi parmi les éléments des groupes IIIA, IVA, VA, VIA, VIIA, VIII, IB et IIB ;

m et n sont des nombres identiques ou différents variant de 1 à 5 inclus, $\delta$ est un nombre variant entre 0 et 1 inclus.

13. Procédé selon l'une des revendications précédentes, caractérisé en ce qu'on utilise le matériau sous forme massique ou sous forme d'une poudre comprimée éventuellement frittée, d'une couche mince ou épaisse, d'un monocristal.

14. Procédé selon l'une des revendications précédentes, caractérisé en ce que l'on réalise l'électrolyse en appliquant à l'électrode formée par le matériau à traiter un potentiel inférieur à celui où l'on constate un dégagement d'oxygène sur ledit matériau.

15. Procédé selon l'une des revendications précédentes, caractérisé en ce qu'on réalise l'électrolyse en appliquant à l'électrode formée par le matériau précité, un potentiel d'au moins 200 mV et plus particulièrement compris entre 200 et 1500 mV, ce potentiel étant déterminé par rapport à une électrode de référence au mercure HgO/Hg.

16. Procédé selon l'une des revendications précédentes, caractérisé en ce qu'on forme le milieu liquide avec une base qui est un hydroxyde alcalin ou alcalino-terreux ou un mélange de ceux-ci.

17. Procédé selon l'une des revendications précédentes, caractérisé en ce que l'électrolyse précitée est effectuée à une température inférieure à 100°C, notamment à la température ambiante.

18. Matériau supraconducteur ou à comportement semi-conducteur ou métallique, caractérisé en ce qu'il est obtenu à partir d'un premier matériau sous forme oxyde traité par un procédé dans lequel ledit premier matériau est utilisé comme électrode dans une électrolyse dans un milieu liquide notamment neutre ou basique et plus particulièrement aqueux.

19. Matériau selon la revendication 18, caractérisé en ce qu'il est obtenu à partir d'un oxyde de type pérovskite ou dérivé de la pérovskite.

20. Matériau selon la revendication 19, caractérisé en ce qu'il correspond aux formules suivantes :

$$A_{1-x} A'_{x'} BO_{3 \pm y} \quad (1)$$

$$A_{n+1} B_n O_{3n+1 \pm \delta} \quad (2)$$

$$(AO)_m A'_2 A"_{n-1} B_n O_{2n+2 \pm \delta} \quad (3)$$

$$(AO)_m A'_2 A"_{n-1} B_{n+1} O_{2n+2 \pm \delta} \quad (4)$$

$$(AO)_m A'_{n-1} B_n O_{3n+1 \pm \delta} \quad (5)$$

dans lesquelles :

. A et A" dans les formules (1) (2) (3) et (4) et A' dans la formule (1) sont choisis parmi les éléments des groupes IA, IIA, IIIA, IIIB, IVB, VB et les éléments de la série 4f ;

. A' dans les formules (3) et (4) sont choisis parmi les éléments des groupes IA, IIA et IIIA ;

. B dans les formules (1) à (5) est choisi parmi les éléments des groupes IIIA, IVA, VA, VIA, VIIA, VIII, IB, IIB ;

. x, x', y, $\delta$ identiques ou non, varient entre 0 et 1 inclus,

. n $\geq$ 1 et plus particulièrement dans la formule (5) n varie entre 1 et 5 inclus ;

. m est compris entre 1 et 2 inclus dans les formules (3) et (4) ;

. m identique ou non à n, varie entre 1 et 5 inclus dans la formule (5) ;

Plus particulièrement, dans le cas des formules (3) et (4) :

A = Pb, Bi ou Tl ; A' = Sr ou Ba ; A" = Ca, Sr ou Y ;

Dans le cas de la formule (5) :

A = Bi ; A' = Sr, Ba, Pb ou Bi.

21. Matériau supraconducteur de formule $La_2CuO_4 \pm \delta$ caractérisé en ce qu'il présente les paramètres de maille suivants :

a = 5,351 Å

b = 5,420 Å

c = 13,227 Å.

FIG.1

FIG.2

EP 0 434 480 A1

FIG.3

EP 0 434 480 A1

Office européen
des brevets

# RAPPORT DE RECHERCHE EUROPEENNE

Numero de la demande

EP 90 40 3243

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | WO-A-8 907 161 (MASSACHUSETS INSTITUTE OF TECHNOLOGY, US) * Document en entier * | 1-21 | C 04 B 35/00 H 01 L 39/24 C 25 D 11/00 C 04 B 41/00 |
| A | JOURNAL OF THE ELECTROCHEMICAL SOCIETY, vol. 135, no. 6, juin 1988, pages 1607-1608; D.J. ZURAWSKI et al.: "Towards the electrochemical synthesis of high temperature superconductors" * Document entier * | 1-21 | |
| A | WORLD PATENT INDEX LATEST, semaine 02, accession no. 89.013478, Derwent Publications Ltd, Londres, GB; & JP-A-63 291 318 (FUJIKURA CABLE WORKS K.K.) 29-11-1988 | 1-21 | |

DOMAINES TECHNIQUES RECHERCHES (Int. Cl.5)

C 25 D
C 04 B

Le présent rapport a été établi pour toutes les revendications

| Lieu de la recherche | Date d'achèvement de la recherche | Examinateur |
|---|---|---|
| LA HAYE | 08-03-1991 | RIGONDAUD B.P.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)